(19) Europäisches Patentamt

European Patent Office

Office européen des brevets

(11) EP 0 340 694 B1

## (12) EUROPEAN PATENT SPECIFICATION

(45) Date of publication and mention
of the grant of the patent:
**26.02.1997 Bulletin 1997/09**

(51) Int Cl.6: **G06F 7/58**, G06F 11/26,
G01R 31/28

(21) Application number: **89107840.4**

(22) Date of filing: **29.04.1989**

(54) **Test pattern generator**

Prüfmustergenerator

Générateur de configurations de test

(84) Designated Contracting States:
**DE FR GB**

(30) Priority: **05.05.1988 US 190611**

(43) Date of publication of application:
**08.11.1989 Bulletin 1989/45**

(73) Proprietor: **SAMSUNG ELECTRONICS CO., LTD.**
**Chung-Ku, Seoul (KR)**

(72) Inventor: **Avra, LaNae**
**Plymouth, MN 55442 (US)**

(74) Representative:
**Tunstall, Christopher Stephen et al**
**Dibb Lupton Broomhead,**
**117 The Headrow**
**Leeds, West Yorkshire LS1 5JX (GB)**

(56) References cited:
**US-A- 3 816 764**

- **IEEE INTERNATIONAL CONFERENCE ON COMPUTER-AIDED DESIGN, Santa Clara, California, 11th-13th November 1986, pp 56-59, IEEE, New York, US; L.-T. WANG et al.: "Complete feedback shift register design for built-in self-test"**
- **INTERNATIONAL TEST CONFERENCE 1986 PROCEEDINGS, TESTINGS'S IMPACT ON DESIGN & TECHNOLOGY, 8th-11th September 1986, pp 38-47, IEEE, New York, US; L.-T. WANG et al.: "A hybrid design of maximum-length sequence generators"**

**Description**

The present invention relates to a test pattern generator according to the preamble ot the independent claims as it is used in circuit testing and, more particularly, to modified n-bit linear feed-back shift register (LFSR) circuit designs.

Traditionally, large scale integrated circuits have needed to be tested for defects or flaws. When only a fraction of the total components produced by a manufacturing process are "good" (i.e., meet the requirements of specifications), something must separate the "good" components from components which contain defects or flaws. Testing does this by applying input stimulus (input test patterns) to the device-under-test and comparing the outputs of the device-under-test with the expected "good" results.

In the past, test pattern generation has been done by hand or with a limited amount of aid from a computer. As the designs of the circuits being tested become increasingly complex, the test time required to generate test patterns by hand increases significantly. For sequential circuitry, the time required has grown at a rate proportional to the number of gates cubed. In reality, costs of manual test pattern generation have not increased at this rate. Rather than invest the time and money required to obtain test results with complete fault coverage, designers often take short cuts which result in inadequate and low-quality test sets.

At the present time the cost of testing depends a great deal on the capital expenditures required for automatic test equipment (ATE). Further, as the number of component input and output pins in the tested circuits increases, and as the components operate at higher frequencies, the complexity and cost of ATE increases. Furthermore, as the complexity of the components increases, so does the number of test patterns. This increase in the number of test patterns results in an increase in test time which then relates to a requirement for additional ATE capacity. Today, a single integrated circuit tester can cost in excess of two million dollars. The price of an hour of testing time can be considerable given the depreciation costs of a circuit tester, tester maintenance costs, and the cost of test engineering support.

An alternative to multi-million-dollar chip testing exists. Designers can incorporate a number of simple design techniques into their circuit design which will reduce the cost of test pattern generation and application while actually allowing better test quality. In addition, it is possible to build into the circuit to be tested a number of capabilities typically required of external test equipment. These built-in self-test (BIST) techniques can greatly simplify automatic test equipment requirements and can result in significant costs savings.

Although testability-improvement techniques and built-in self-test techniques are attractive from the perspective of test cost reduction, they carry with them some significant costs which must be evaluated. Most design-for-test techniques consume chip real estate, power, I/O pins and may impact the speed performance of the circuit during normal operation.

Designs which use built-in self-test provide for generation of input stimulus and evaluation of the circuit response within the actual circuit design. To minimize the on-chip circuitry, external sequencing of the self-test operation is often used. A variety of methods exist for both providing the input stimulus and evaluating the circuit response. Among the most widely used self-test techniques are parallel built-in self-tests of ROMs/RAMs and pseudo-random self-tests.

The addition of a counter to an existing circuit design would enable most built-in self-test techniques to generate test patterns. However, a relatively high number of gates are required to form a counter and a counter does not generate patterns in a pseudo-random fashion. Consequently, many built-in self-test techniques use linear feedback shift registers (LFSR). A LFSR can provide the same test patterns as a counter but can be implemented with a smaller number of gates than a counter of the same number of bits. As a result, the impact on the chip is minimized. In addition, modified versions of the LFSR can be used for both test pattern generation and for compaction of the test results.

The output of an n-bit linear feedback shift register is a pattern of 0's and 1's which is n-bits long. In this case, a bit is an abbreviation for an element of memory which can represent a single binary digit such as a "1" or a "0", and n is in reference to the variability of the length of the register (i.e. number of bits). Thus, the number of possible patterns or states for an n-bit linear feedback shift register is $2^n$. If we start the linear feedback shift register in one of these states, it then progresses through some sequence of these states. It can be shown that a periodic succession of states will ultimately result. The feedback function $F(X_1, X_2,...X_n)$ can be expressed in the form:

$$F(X_1, X_2,...,X_n) = C_1 X_1 \oplus C_2 X_2 \oplus ... \oplus C_n X_n$$

If for each of the constants C, C is either a "0" or a "1", and if the symbol $\oplus$ denotes the exclusive-or (XOR) or the addition module 2 function (wherein the result is "1" for the odd sums and "0" for even sums), then the shift register is called linear. A characteristic of linear feedback is that the value of any of the signals used in the feedback network will have an equal weight in determining the feedback value. Therefore, the resulting test sequence will be pseudo-random in nature. By properly choosing the linear feedback network, the state sequence of an n-bit LFSR can be maximized to a length of $2^n-1$ different states. Even with a maximum-length LFSR one state of the LFSR is not included in the sequence. This missing state is often called the "stuck-state" because if the LFSR is initialized to this state, it remains stuck and does not transition to any other state. The inability of an LFSR to generate the entire sequence of $2^n$ different states (input test patterns) can be an undesirable feature in some testing situations.

Current designs which solve the problem of generating the entire set of input test patterns exist. However, they require the modification of the registers by adding XOR gates between bitslices. This solution entails building complex, non-standard and expensive registers, which are undesirable if a standard register design exists in a cell library.

IEEE International Conference on CAD, November 1986, pp. 56-59, "Complete Feedback Shift Register Design for Built-in Self Test" describes a circuit with additional logic which detects the presence of certain states and then inserts into the first bit of the 4-bit register in the next stage the complement of the bit which would normally be inserted according to the cycle logic of the test pattern generator. The same document also describes arrangements which include XOR gates between the bits of the the shift register.

US patent no. 3816764 discloses a similar arrangement to that described in the IEEE reference. The logic switches between two distinct cycles each of length $2^{n-1}$. IEEE International Test Conference, September 1986, pp. 38-47, "A Hybrid Design of Maximum-Length Sequence Generators" describes generators which include XOR gates between the bits of the shift register.

It is an object of the present invention to devise test pattern generators which may use a standard register design and which are able to generate a complete set of $2^n$ test patterns.

According to the present invention, there is provided an exhaustive test pattern generator for generating $2^n$ test patterns comprising:

a maximum-length linear feedback shift register including an n-stage shift register and cycle logic circuitry for generating a sequence of $2^{n}-1$ test patterns in the n-stage shift register, the cycle logic circuitry normally providing the input to be latched into the first stage of the shift register in the next cycle;

additional logic circuitry external to the n-stage shift register for providing a TRUE output when the first n-1 stages of the n-stage shift register coincide with the stuck state of the linear feedback shift register, the stuck state being the test pattern normally missed when using the LFSR to generate a test pattern sequence;

output means for providing at least one of the $2^n$ test patterns; and **characterised by**

a multiplexer having a first input receiving the output of the cycle logic circuitry; a second input receiving whichever of the last stage output or the inverted last stage output of the shift register always corresponds to the complement of the output of the cycle logic circuitry when the output of the additional logic circuit is TRUE; a selection input receiving the output of the additional logic circuit; and an output coupled to the input of the first stage of the shift register;

wherein when the output of the additional logic circuit is TRUE the additional logic circuitry and the multiplexer insert into the first stage of the n-stage shift register in the next cycle the complement of the bit which would normally be inserted according to the cycle logic circuitry of the linear feedback shift register.

The present invention overcomes the problem of generating an incomplete set of input test patterns (e,g. $2^{n}-1$ test patterns) for testing a chip or circuit. Through the present invention, a complete set of input test patterns (ie, $2^n$ test patterns) is generated, and this is accomplished in a manner which minimizes the necessary modifications to the integrated circuit design and in a manner which minimizes the number of gates that must be added to the integrated circuit design.

In the present invention, modifying circuitry is added to the feedback network connected to a standard register rather than modifying the standard register itself. Therefore, the modifications made to the test pattern generator do not impact the basic register design. A maximum-length test patten generator using the present invention includes n memory devices such as an n-bit register, a feedback network and modifying circuitry to allow for $2^n$ test patterns to be generated.

Preferably, the cycle logic circuitry (166) is adapted to generate a pseudo-random test pattern sequence.

The test pattern generator may further comprise initializing means (100, 104) for setting the initial value of the n-stage shift register (155).

The additional logic circuitry logically comprises a multiplexer (110) and additional combinational logic (108). The additional combinational logic (108) may include means for providing to the multiplexer a selecting signal consisting of a logical AND of a plurality of outputs (140-144) of the shift register stages (120-125).

The outputs (140-144) of the shift register stages (120-125) may be non-inverted or inverted outputs. The combinational logic may then comprise means for logically coupling the non-inverted or inverted output (145) of the $n^{th}$ stage (125) of the n-stage shift register (155) to an input of the multiplexer (110).

The present invention will now be desribed by way of example with reference to the accompanying drawings in which:

Fig 1 is a prior art linear feedback shift register (LFSR);
Fig 2 is a prior art apparatus which can generate $2^n$

unique test patterns. The circuit is known as a modified maximum length sequence generator (MLSG);

Fig. 3 is a drawing showing a general schematic diagram of an embodiment of an exhaustive TPG generator (exhaustive TPG) which follows the concepts of the present invention.

Fig. 4 is a drawing showing a general schematic diagram of an alternative embodiment of an exhaustive TPG which follows the concepts of the present invention.

Fig. 5 is a diagram showing the preferred embodiment of an exhaustive TPG utilizing the concepts of the present invention.

Fig. 6 is a diagram showing an alternative preferred embodiment of an exhaustive TPG.

Fig. 7 is a diagram showing an alternative preferred embodiment of an exhaustive TPG.

Fig. 8 is a diagram showing an alternative preferred embodiment of an exhaustive TPG.

Fig. 9 is a diagram showing an alternative preferred embodiment of an exhaustive TPG.

Fig. 10 is a diagram showing an alternative preferred embodiment of an exhaustive TPG.

Fig. 11 is a diagram showing an alternative preferred embodiment of an exhaustive TPG.

Fig. 12 is a diagram showing an alternative preferred embodiment of an exhaustive TPG.

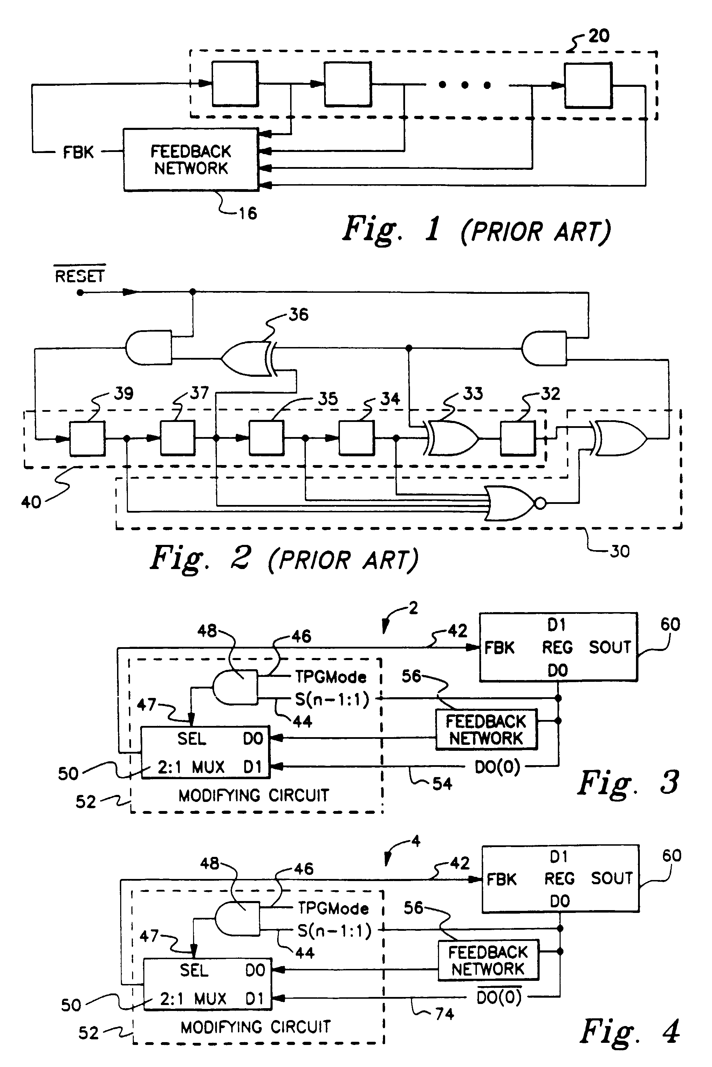

Shown in Figure 1 is a prior art linear feedback shift register (LFSR) comprising a logically serial coupled register 20 and feedback network 16. The maximum number of unique test patterns that can be generated by the circuit is $2^n$-1 where n is the number of one-bit memory devices (i.e. bi-stable multivibrators such as flipflops or latches) logically serial coupled to one another to form register 20.

Shown in Figure 2 is a prior art apparatus which can generate $2^n$ unique test patterns. The circuit, known as a modified maximum length sequence generator (modified MLSG), was suggested by L. T. Wang, et.al. in "A Hybrid Design Of Maximum-Length Sequence Generators," Proceedings-1986 International Test Conference, Paper 1.3. Logically serial coupled register 40 is a modified register wherein an exclusive-or (XOR) gate 33 is inserted into the register to provide a feedback signal. The XOR gate 33, in conjunction with XOR gate 36, comprise a feedback network which when logically coupled with register 40 provides a test pattern sequence of $2^n$-1 unique test patterns. Modifying circuit 30 is logically coupled to register 40 and the feedback network to insert the $2^n$th test pattern into the test pattern sequence. The result is a test pattern sequence of $2^n$ unique patterns. However, this circuit design has the disadvantage of using a highly specialized register 40 with an XOR gate 33 inserted in the sequence of memory devices 32, 34, 35, 37, and 39. Use of specialized circuit designs can increase costs and design time of a circuit as well as decrease the flexibility of the surrounding circuit design.

The present invention overcomes these disadvantages by placing all modifying circuitry outside of the memory device (e.g., a register). This will allow the memory device design to be independent of the feedback network and modifying circuit design. Therefore, standard memory devices may be employed and, as better memory devices are developed, they may be inserted into an overall circuit design utilizing the concepts of the present invention without major design changes. Furthermore, the present invention requires fewer gates for implementation which in turn reduces chip real estate and power consumption.

It should be noted that the specific embodiments described below are described using commonly used positive logic descriptions. However, the scope of the present invention is not limited to procedures and apparatus which use positive as opposed to negative logic. Also, it should be noted that the specific embodiments described below are described using flip-flops. However, any bi-stable multi-vibrator device could be used to implement a procedure or an apparatus which utilizes the concepts of the present invention. Therefore, the scope of the present invention is not limited to the use of flip-flops.

Figure 3 shows a general schematic diagram of an embodiment of an exhaustive test pattern generator (exhaustive TPG) which follows the concepts of the present invention. Exhaustive TPG 2 comprises three elements including shift registers 60, feedback network 56, and modifying circuit 52. Shift register 60 can be any memory device which can react to a serially-loaded input signal and can provide parallel output signals indicative of the states of each bit of the stored "true"/"false" pattern. Feedback network 56 is a circuit which when logically coupled to the serial input and parallel outputs of shift register 60 causes the stored "true"/"false" pattern to sequence through $2^n$-1 unique test patterns, where n is the number of individual "true"/"false" states in shift register 60.

Modifying circuit 52 is external to register 60 and is inserted between shift register 60 and feedback network 56. Modifying circuit 52 is logically coupled to the output of feedback network 56, the plurality of parallel outputs of shift register 60 and the serial input of shift register 60. Modifying circuit 52 inserts the missing $2^n$th state into the test pattern signal sequence so that $2^n$ unique test patterns are generated by shift register 60.

In the embodiment shown, a 2:1 mulitplexer 50 and an AND gate 48 are used to switch between the two input signals provided to a modifying circuit 52. AND gate 48 generates a selecting signal which enables multiplexer 50 to apply a one-bit signal from circuit means 54 into serial input 42 of shift register 60. AND gate 48 has a plurality of inputs including input 46 which transmits a signal indicating that the test pattern generation mode has been initiated.

AND gate input 44, which signifies a plurality of inputs of AND gate 48, is logically coupled to a plurality of inverted and non-inverted parallel outputs of shift register 60. When input 44 equals a certain state (i.e. test pattern) and the signal at input 46 is "true", the selecting signal at selecting input 47 of multiplexer 50 is "true", and a corresponding signal from circuit means 54 is passed through multiplexer 50 to serial input 42 of shift register 60. Circuit means 54 provides the non-inverted output of a stored test pattern signal in shift register 60 which is furthest away from serial input 42. During all other states of input 44 the selecting signal is "false", and the output of feedback network 56 is passed through multiplexer 50 to serial input 42 of register 60. As a result of this switching between inputs of multiplexer 50, a test pattern signal sequence of $2^n$ unique patterns is applied to serial input 42 which causes shift register 60 to generate $2^n$ unique test patterns. This $2^n$ test pattern sequence could be used in exhaustive testing situations where all input states of a circuit should be addressed.

Figure 4 shows an alternative general schematic diagram of an exhaustive TPG 4 which follows the concepts of the present invention. The alternative schematic diagram differs from exhaustive TPG 2 in that circuit means 74 provides an inverted output of the bit which is furthest away from serial input 42. Depending upon the particular schematic diagram, the insertion of the $2^n$th test pattern in some test pattern generators may require an inverted or non-inverted output signal of a register bit (i.e. one "true"/"false" signal). Therefore, two possible general embodiments are shown in Figures 3 and 4 and labeled exhaustive TPG 2 and 4 respectively.

Specific embodiments of the present invention will vary according to the kind of shift register (i.e. inverting and non-inverting), the number of bits (i.e. odd or even) and the stuckstate (i.e. the test pattern normally missed when using an LFSR to generate a test pattern sequence). A shift register which is said to be inverting takes the inverted output of a bit and logically couples it to the following bit's input. In contrast, a shift register is said to be noninverting when it takes the non-inverted output of a bit and logically couples it to the following bit's input.

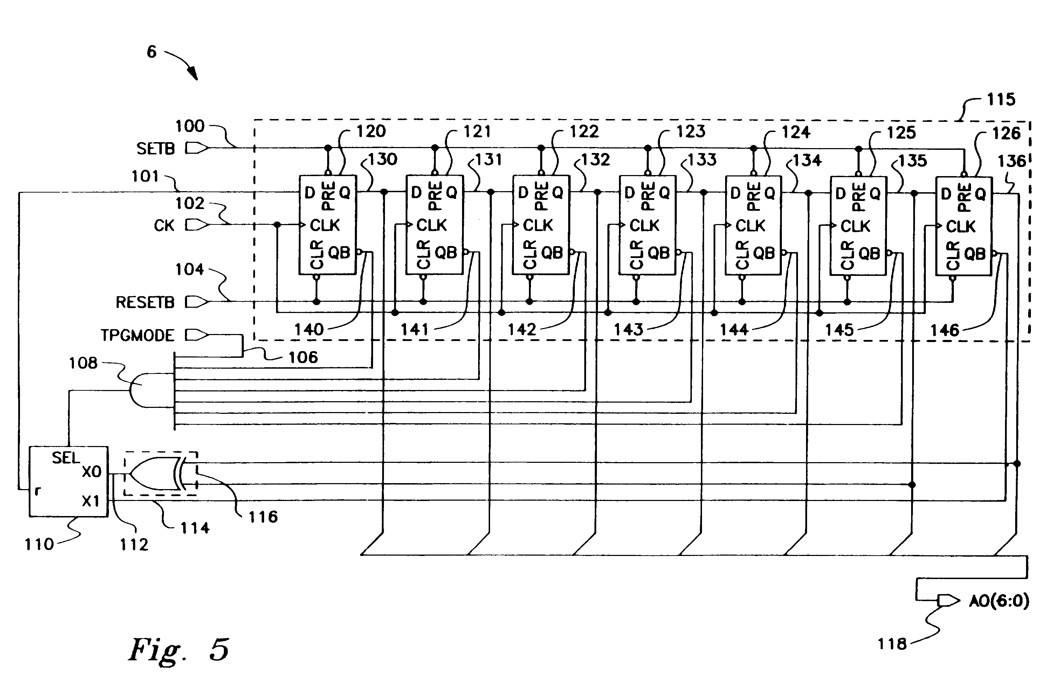

Figure 5 shows a preferred embodiment of an exhaustive TPG utilizing the concepts of the present invention. Exhaustive TPG 6 is a noninverting, odd-bit TPG with a stuck-state of 0000000. Exhaustive TPG 6 comprises a noninverting odd-bit shift register 115, feedback network 116 and a modifying circuit. Shift register 115 is comprised of seven flip-flops 120 through 126. Each flip-flop includes an input, an inverted output (i.e., elements 130 through 136) and a non-inverted output (i.e. elements 140 through 146). Each flip-flop is logically coupled together from an output of a flip-flop to the input of the following flip-flop. An example of this is that the output of flip-flop 120 is logically coupled (e.g., electrically connected) to the input of flip-flop 121 so that a signal may pass between the two flip-flops. Such a logic coupling is generally referred to as serial coupling.

Each of the flip-flops include a PRE input. These inputs are logically coupled together to form an initialization signal input 100 for exhaustive TPG 6. Signal input 100 initializes each of the flip-flops to a "true" (e.g., binary one) state. Similarly, signal input 104 is logically coupled to each flip-flop CLR input so that the flip-flop can be initialized to a "false" (e.g., binary 0) state. These two initializing inputs are important in an exhaustive TPG. These inputs 100 and 104 enable an exhaustive TPG to be started with the same test pattern each time a test pattern sequence is started. It should be noted that it may be advantageous to start a test pattern sequence with a test pattern other than one comprising all "true" states or all "false" states. Each of the flip-flops also includes a CLK input logically coupled together to form signal input 102. Signal input 102 is usually logically coupled to a device external to exhaustive TPG 6 for sequencing the TPG through a plurality of test patterns.

Feedback network 116 provides at output 112 a signal which is the exclusive-or (XOR) function of flip-flop outputs 135 and 136. Feedback network 116 will provide up to $2^7-1$ different test pattern signals in a pseudo-random manner.

The modifying circuit shown comprises element 108 and a 2:1 multiplexer 110. Element 108 provides an output (selecting) signal to multiplexer 110. The selecting signal is generated from the logical AND of the inverted flip-flop outputs 140 through 145 and a TPG mode signal (via input 106) set to a "1" state, where the TPG mode signal set to a "1" state indicates that the exhaustive TPG is supposed to be generating test patterns. When set to "0" state, the TPG mode signal provided via input 106 allows the feedback network to be used for other purposes, such as signature analysis.

The output signal of element 108 is usually a "0" state; when that is the case, multiplexer 110 selects and passes the feedback network output signal from output 112 to input 101. When flip-flops 120 through 125 are set to a "0" state and flip-flop 126 is set to a "1" state, element 108 outputs a "1" state which configures multiplexer 110 to pass the signal at input 114 through multiplexer 110 to register input 101. Input 114 is logically coupled to register output 146, which provides a "0" state signal. Thus, a "0" state signal is input into flip-flop 120, and the previous states of flip-flops 120 through 125 are shifted into 121 through 126 respectively. The result is that the $2^7$th (stuck state) test pattern 0000000 is inserted into the test pattern sequence. Once this pattern is reached, element 108 provides an output signal set to "1", and multiplexer input 114 is selected and passed through to register input 101.

Input 114, which is logically coupled to output 146, is a "1" state. Therefore, the next test pattern held in the flip-flops is 1000000. Thus, element 108 provides an AND function output signal of a "0" state, and exhaustive TPG 6 returns to selecting the feedback network signal from output 112 and thus passes that signal through multiplexer 110 to input 101.

Through this process, exhaustive TPG 6 will generate a test pattern sequence to output data bus 118 (which is logically coupled to flip-flop outputs 130 through 136) to provide a test pattern to an external device. The test pattern sequence generated will include $2^7$ different test patterns.

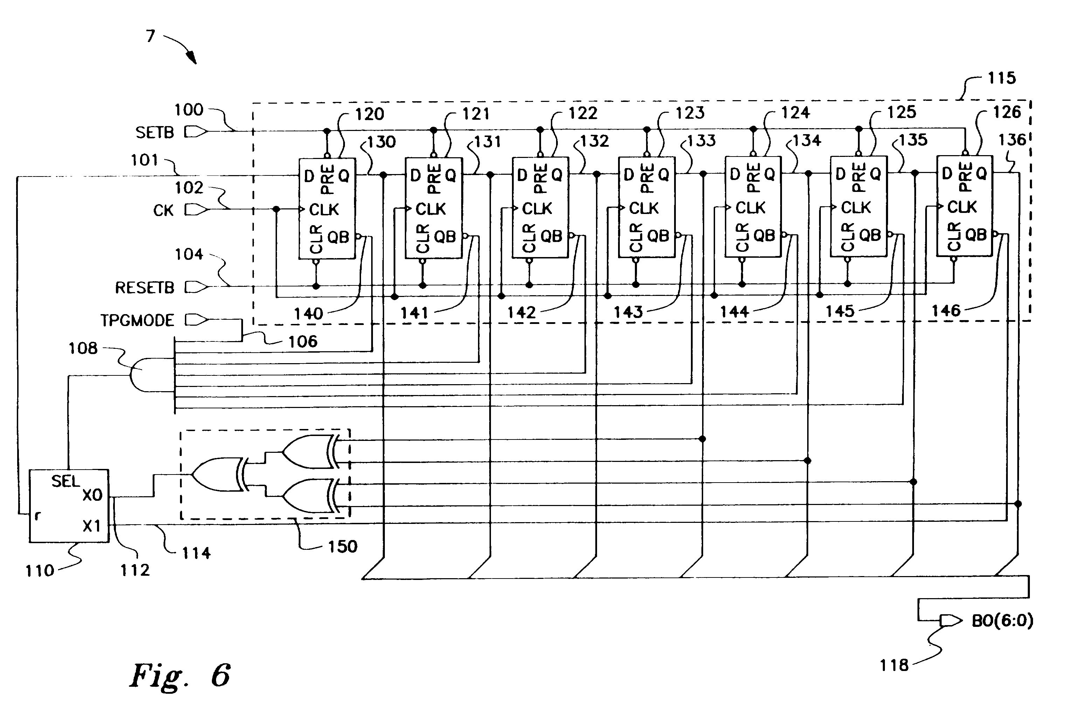

Exhaustive TPG 7 shown in Figure 6 is another preferred embodiment and is the same as exhaustive TPG 6 shown in Figure 5 except for feedback network 150. Feedback network 150 provides an output signal at 112 which is the XOR function of flip-flop outputs 133 through 136. Feedback network 150 will provide a $2^7$-1 test pattern signal sequence different from feedback network 116. Consequently, test pattern signal sequence exhaustive TPG 7 will provide a sequence of $2^7$ different test patterns distinguishable from the sequence produced by exhaustive TPG 6.

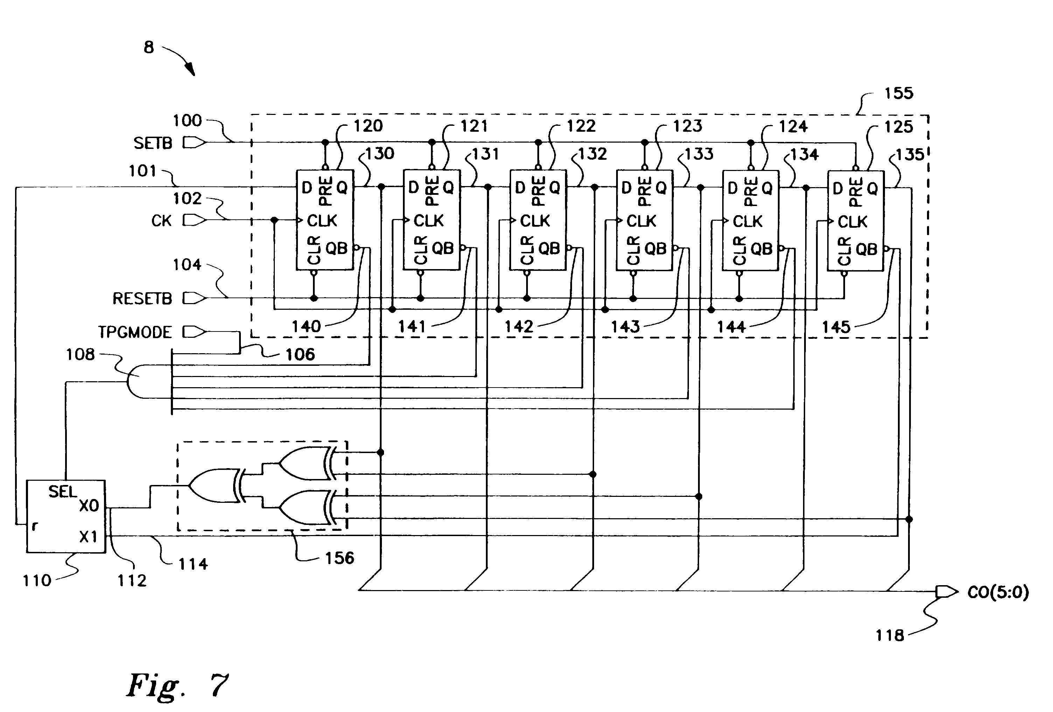

Figure 7 shows another preferred embodiment of an exhaustive TPG utilizing the concepts of the present invention. Exhaustive TPG 8 is a noninverting, even-bit TPG with a stuck state of 000000. Exhaustive TPG 8 differs from exhaustive TPG 6 in that shift register 155 is even-bit and feedback network 156 is logically coupled differently to shift register 155. Shift register 155 contains six flip-flops and therefore is considered even-bit. As a result of their being only six flip-flops, one less output of the flip-flops is logically coupled to element 108. Output 135 is no longer needed for the correct selecting signal to be generated. Feedback network 156 provides an output signal at 112 which is the XOR function of flip-flop outputs 130, 132, 133, and 135. Feedback network 156 will provide a $2^6$-1 test pattern signal sequence. Consequently, exhaustive TPG 8 will provide a sequence of $2^6$ different test patterns.

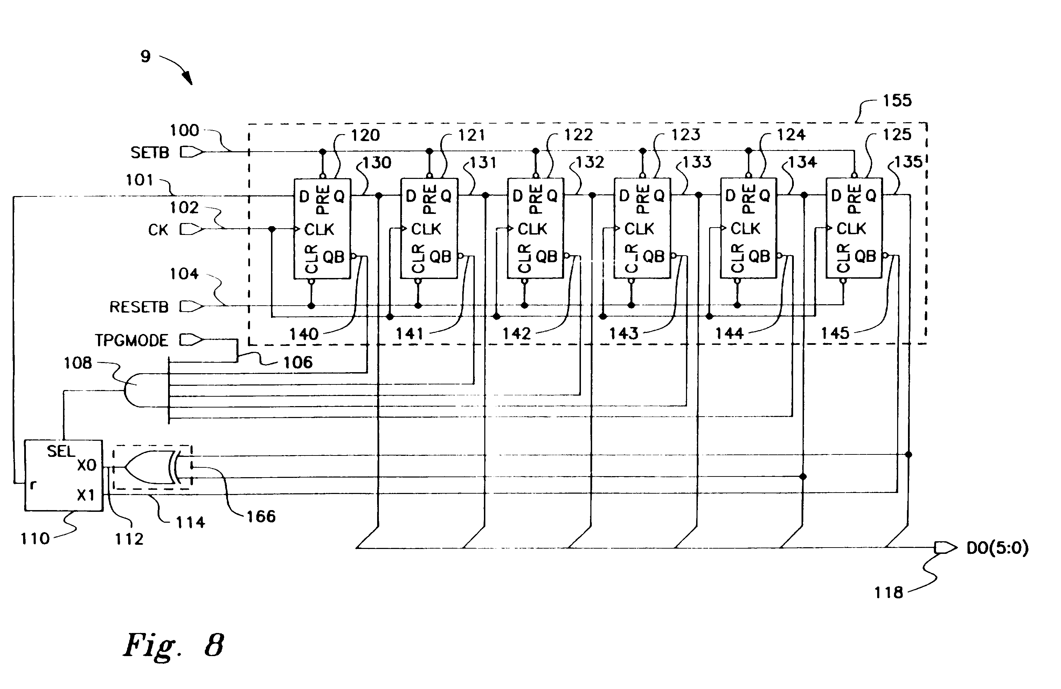

Figure 8 shows another preferred embodiment of an exhaustive TPG utilizing the concepts of the present invention. Exhaustive TPG 9 differs from exhaustive TPG 8 in that feedback network 166 is logically coupled differently to shift register 155 and provides a different output signal 112. Feedback network 166 provides an output signal at 112 which is the XOR function of flip-flop outputs 134 and 135. Feedback network 166 will provide a $2^6$-1 test pattern signal sequence different from feedback network 156. Consequently exhaustive TPG 9 will provide a sequence of $2^6$ different test patterns distinguishable from the sequence produced by exhaustive TPG 8.

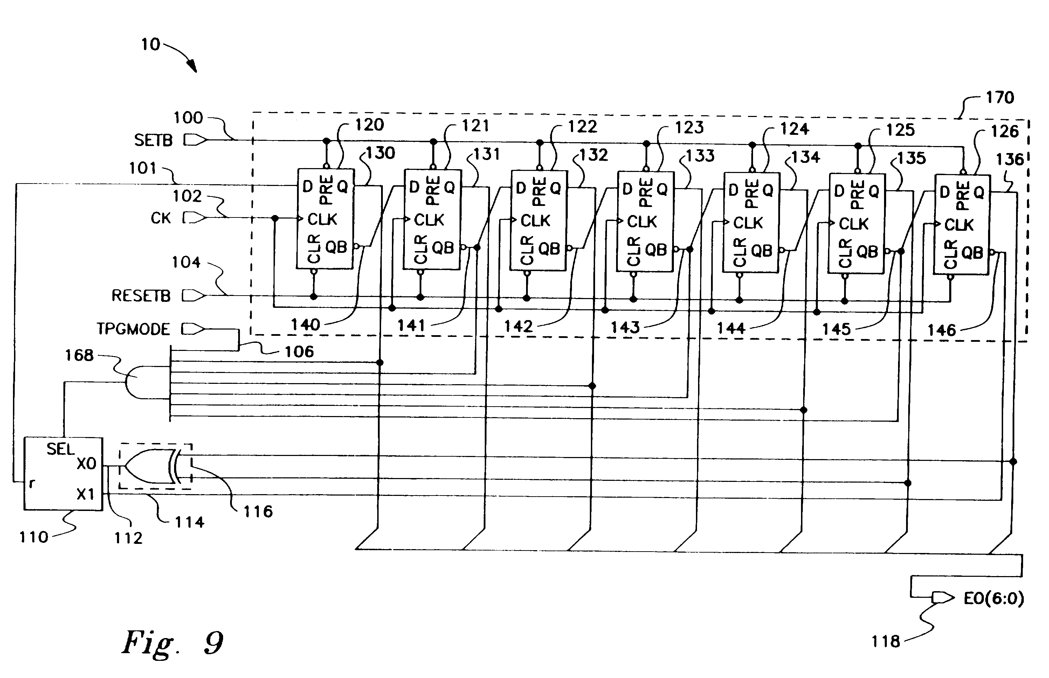

Figure 9 shows another preferred embodiment of an exhaustive TPG utilizing the concepts of the present invention. Exhaustive TPG 10 is an inverting, odd-bit TPG with a stuck state of 1010101. Exhaustive TPG 10 differs from exhaustive TPG 6 in that the shift register is inverting and element 168 is logically coupled differently to shift register 170 which causes a different stuck state. Shift register 170 is said to be inverting because the inverted output of a flip-flop is logically coupled to the input of the following flip-flop. An example of this is that the inverted output of flip-flop 120 is logically coupled to the input of flip-flop 121 so that a signal may pass between them.

Element 168 provides a selecting signal to multiplexer 110 which is generated from the logical AND of the TPG mode signal 106, the noninverted flip-flop outputs 130, 132 and 134 as well as the inverted flip-flop outputs 141, 143 and 145. When the non-inverted outputs of flip-flops 120 through 126 reach the test pattern 1010100, element 168 sends a selecting signal to multiplexer 110, which selects input 114. The result is that the $2^o$'th (stuck state) test pattern 1010101 is inserted into the test pattern sequence. Once this pattern is reached, element 108 continues to provide an enabling signal to multiplexer 110 which selects input 114 so that test pattern 0101010 is generated. This new pattern causes the selecting signal of element 108 to select the feedback network output signal at 112. As a result, exhaustive TPG 10 inserts the $2^7$th test pattern into the $2^7$-1 test pattern sequence. Consequently, exhaustive TPG 10 will provide a sequence of $2^7$ different test patterns.

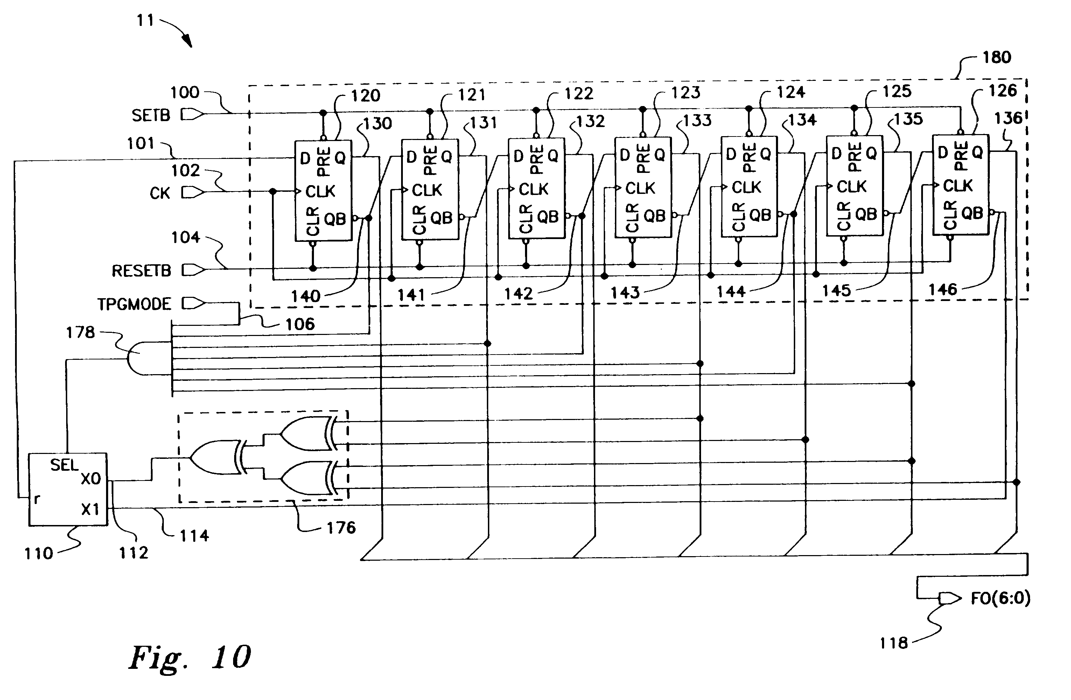

Figure 10 shows another preferred embodiment of an exhaustive TPG utilizing the concepts of the present invention. Exhaustive TPG 11 is an inverting, odd-bit TPG with a stuck state of 0101010. Exhaustive TPG 11 differs from exhaustive TPG 10 in that element 178 and feedback network 176 are logically coupled differently to shift register 180. Element 178 provides a selecting signal to multiplexer 110 generated from the logical AND of TPG mode signal 106, the non-inverted flip-flop outputs 131, 133, and 135 as well as the inverted flip-flop outputs 140, 142, and 144.

When the non-inverted outputs of flip-flops 120 through 126 reach the test pattern 0101011, element 178 sends a selecting signal to multiplexer 110 which selects input 114. The result is that the $2^7$th (stuck state) test pattern 0101010 is inserted into the test pattern sequence. Once this pattern is reached, element 178 continues to provide a selecting signal to multiplexer 110 which selects input 114 so that test pattern 1010101 is generated. This new pattern causes the selecting signal of element 178 to select the feedback network output signal at 112. Feedback network 176 provides an output signal at 112 which is the XOR function of flip-flop outputs 133 through 136. Feedback network 176 will provide a $2^{7'}$-1 test pattern sequence different from feedback network 116. As a result exhaustive TPG 11 inserts the $2^7$th test pattern into the $2^7$-1 test pattern sequence. Consequently, exhaustive TPG 11 will provide a sequence of $2^7$ different test patterns.

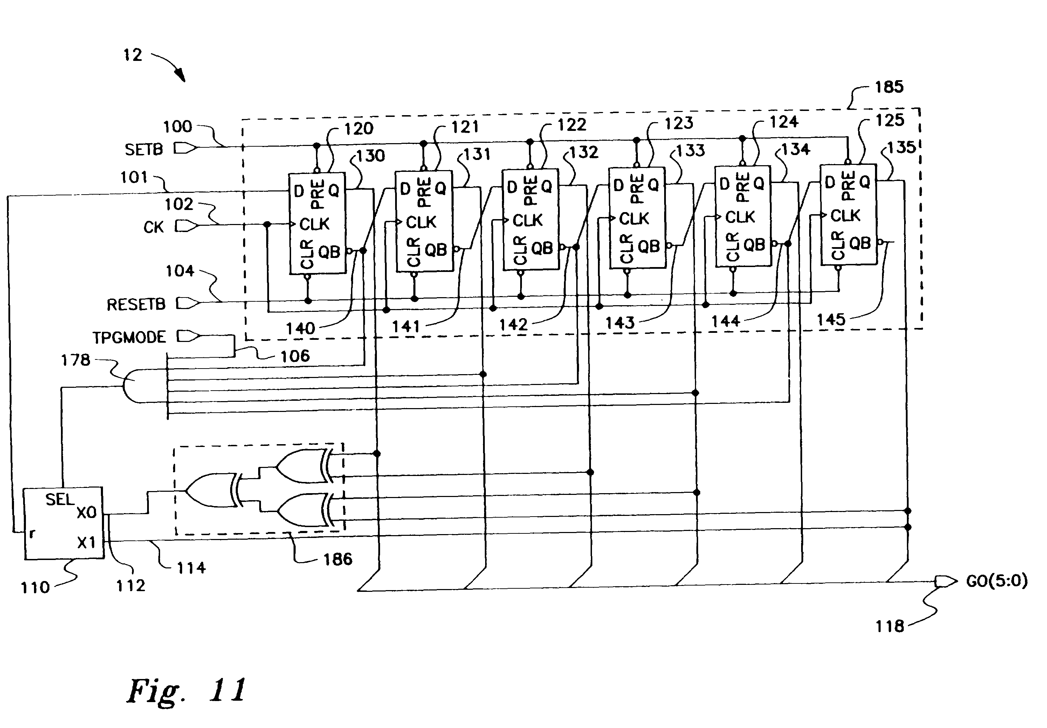

Figure 11 shows another preferred embodiment of an exhaustive TPG utilizing the concepts of the present invention. Exhaustive TPG 12 is an inverting, even-bit TPG with a stuck state of 010101. Exhaustive TPG 12 differs from exhaustive TPG 11 in that shift register 185 is even-bit, feedback network 186 is logically coupled differently to shift register 185 and signal 114 is logically coupled differently to shift register 185. Shift register 185 contains six flip-flops and therefore is considered even-bit. As a result of having only six flip-flops one less output is logically coupled to element 178. Output 135 is no longer needed for the correct selecting signal to be generated. Feedback network 186 provides an output signal 112, which is the XOR function of flip-flop outputs 130, 132, 133, and 135. Feedback network 186 will provide a $2^{6"}$-1 test pattern signal sequence. Consequently, exhaustive TPG 12 will provide a sequence of $2^6$ different test patterns.

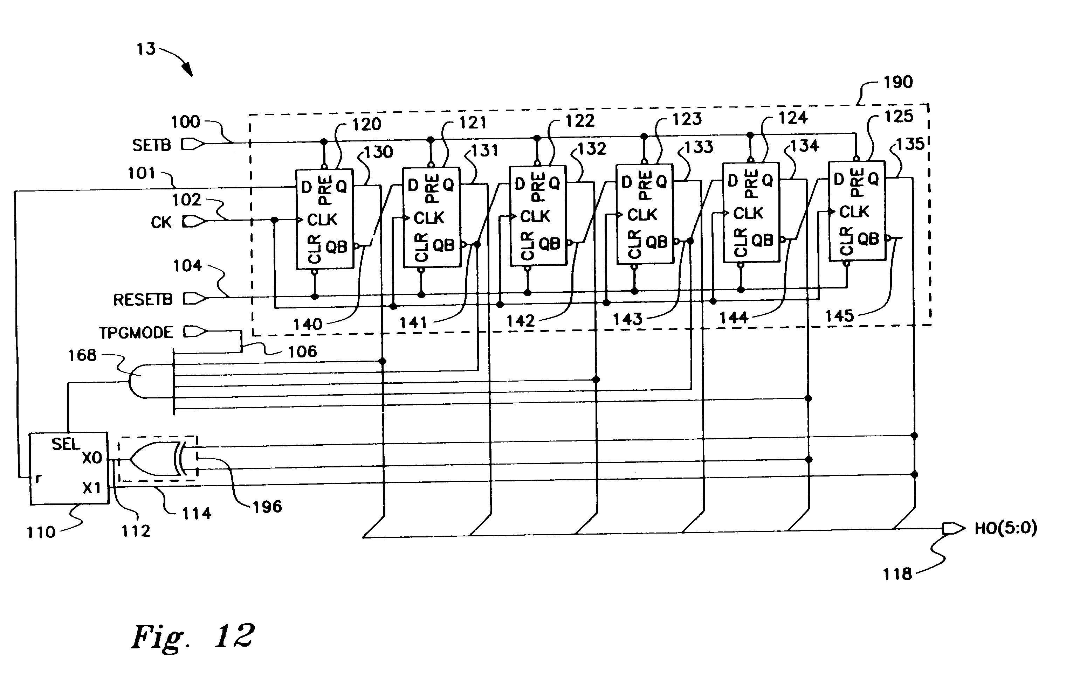

Figure 12 shows another preferred embodiment of an exhaustive TPG utilizing the concepts of the present invention. Exhaustive TPG 13 is an inverting, even-bit TPG with a stuck state of 101010. Exhaustive TPG 13 differs from exhaustive TPG 10 in that shift register 190 is even-bit, feedback network 196 is logically coupled differently to shift register 190 and signal 114 is logically coupled differently to shift register 190. Shift register 190 contains six flip-flops and therefore is considered even-bit. As a result of only having six flip-flops, one less output is logically coupled to element 168. Output 135 is no longer needed for the correct selecting signal to be generated. Feedback network 196 provides an output signal at 112 which is the XOR function of flip-flop outputs 134 and 135. Feedback network 196 will provide a $2^{6"}$-1 test pattern signal sequence. Consequently, exhaustive TPG 13 will provide a sequence of $2^6P$ different test patterns.

### Claims

1. An exhaustive test pattern generator for generating $2^n$ test patterns comprising:

   a maximum-length linear feedback shift register including an n-stage shift register (155) and cycle logic circuitry (166) for generating a sequence of $2^n$-1 test patterns in the n-stage shift register (155), the cycle logic circuitry normally providing the input to be latched into the first stage of the shift register in the next cycle;

   additional logic circuitry (110, 108) external to the n-stage shift register (155) for providing a TRUE output when the first n-1 stages of the n-stage shift register (155) coincide with the stuck state of the linear feedback shift register, the stuck state being the test pattern normally missed when using the LFSR to generate a test pattern sequence;

   output means for providing at least one of the $2^n$ test patterns; and **characterised by**

   a multiplexer having a first input receiving the output of the cycle logic circuitry; a second input receiving whichever of the last stage output or the inverted last stage output of the shift register always corresponds to the complement of the output of the cycle logic circuitry when the output of the additional logic circuit is TRUE; a selection input receiving the output of the additional logic circuit; and an output coupled to the input of the first stage of the shift register;

   wherein when the output of the additional logic circuit is TRUE the additional logic circuitry and the multiplexer insert into the first stage (120) of the n-stage shift register (155) in the next cycle the complement of the bit which would normally be inserted according to the cycle logic circuitry of the linear feedback shift register.

2. A test pattern generator according to claim 1 in which the cycle logic circuitry (166) is adapted to generate a pseudo-random test pattern sequence.

3. A test pattern generator according to claim 1 or claim 2 further comprising initializing means (100, 104) for setting the initial value of the n-stage shift register (155).

4. A test pattern generator according to claim 4 in which the additional logic circuitry (108) comprises means for providing to the selection input of the multiplexer a signal consisting of a logical AND of a plurality of outputs (140-144) of the shift register stages (120-125).

5. A test pattern generator according to claim 4 in which the outputs (140-144) of the shift register stages (120-125) are non-inverted or inverted outputs.

### Patentansprüche

1. Erschöpfender Prüfmustergenerator zur Erzeugung von $2^n$ Prüfmustern mit folgendem:

   einem Schieberegister maximaler Länge mit linearer Rückkopplung mit einem n-Stufen-Schieberegister (155) und Zykluslogikschaltungen (166) zur Erzeugung einer Folge von $2^n$-1 Prüfmustern im n-Stufen-Schieberegister (155), wobei die Zykluslogikschaltungen normalerweise die in die erste Stufe des Schieberegisters im nächsten Zyklus einzuspeichernde Eingabe bereitstellen;
   n-Stufen-Schieberegister(155)-externen zusätzlichen Logikschaltungen (110,108) zur Bereitstellung einer Ausgabe WAHR, wenn die ersten n-1 Stufen des n-Stufen-Schieberegisters (155) mit dem haftenden Zustand des Schieberegisters mit linearer Rückkopplung zusammentreffen, wobei der haftende Zustand das Prüfmuster ist, das normalerweise bei Benutzung des LFSRs zur Erzeugung einer Prüfmusterfolge fehlt;

Ausgabemitteln zur Bereitstellung von mindestens einem der $2^n$ Prüfmuster; gekennzeichnet durch

einen Multiplexer mit einem ersten Eingang, der die Ausgabe der Zykluslogikschaltungen aufnimmt; einem zweiten Eingang, der entweder die Ausgabe der letzten Stufe oder die invertierte Ausgabe der letzten Stufe des Schieberegisters aufnimmt, je nachdem welche stets dem Komplement der Ausgabe der Zykluslogikschaltungen entspricht, wenn die Ausgabe der zusätzlichen Logikschaltung WAHR ist; einem Ansteuerungseingang, der die Ausgabe der zusätzlichen Logikschaltung aufnimmt; und einem an den Eingang der ersten Stufe des Schieberegisters angekoppelten Ausgang; wobei, wenn die Ausgabe der zusätzlichen Logikschaltung WAHR ist, die zusätzlichen Logikschaltungen und der Multiplexer im nächsten Zyklus das Komplement des Bits in die erste Stufe (120) des n-Stufen-Schieberegisters (155) einfügen, das normalerweise entsprechend der Zykluslogikschaltungen des Schieberegisters mit linearer Rückkopplung eingefügt werden würde.

2. Prüfmustergenerator nach Anspruch 1, wobei die Zykluslogikschaltungen (166) zur Erzeugung einer pseudozufallsmäßigen Prüfmusterfolge geeignet sind.

3. Prüfmustergenerator nach Anspruch 1 oder Anspruch 2, weiterhin mit Initialisierungsmitteln (100, 104) zum Einstellen des Anfangswertes des n-Stufen-Schieberegisters (155).

4. Prüfmustergenerator nach Anspruch 4, wobei die zusätzlichen Logikschaltungen (108) Mittel zum Bereitstellen eines aus einem logischen UND einer Mehrzahl von Ausgaben (140-144) der Schieberegisterstufen (120-125) bestehenden Signals für den Ansteuereingang des Multiplexers umfassen.

5. Prüfmustergenerator nach Anspruch 4, wobei die Ausgaben (140-144) der Schieberegisterstufen (120-125) nichtinvertierte oder invertierte Ausgaben sind.

**Revendications**

1. Générateur de motifs de contrôle exhaustif pour générer $2^n$ motifs de contrôle, comprenant :

un registre de retour linéaire d'une longueur maximale comprenant un registre à décalage (155) à n étages et des circuits logiques cycliques (166) pour générer une séquence de $2^n-1$ motifs de contrôle dans le registre à décalage (155) à n étages, les circuits logiques cycliques assurant normalement le verrouillage de l'entrée dans le premier étage du registre à décalage au cours du cycle suivant;

des circuits logiques supplémentaires (110, 108) externes au registre à décalage (155) à n étages pour fournir une sortie VRAI lorsque les premiers étages n-1 du registre à décalage (155) à n étages coïncident avec l'état bloqué du registre de retour linéaire, l'état bloqué étant le motif de contrôle manquant normalement lors de l'utilisation du LFSR pour générer une séquence de motifs de contrôle;

des moyens de sortie pour fournir au moins un des $2^n$ motifs de contrôle; et caractérisé par

un multiplexeur comportant une première entrée recevant la sortie des circuits logiques cycliques; une seconde entrée recevant la sortie du dernier étage ou la sortie inversée du dernier étage du registre à décalage qui correspond toujours au complément de la sortie des circuits logiques cycliques lorsque la sortie du circuit logique supplémentaire est VRAI; une entrée de sélection recevant la sortie du circuit logique supplémentaire, et une sortie couplée à l'entrée du premier étage du registre à décalage;

dans lequel, lorsque la sortie du circuit logique supplémentaire est VRAI, les circuits log ques supplémentaires et le multiplexeur insèrent, dans le premier étage (120) du registre à décalage (155) à n étages au cours du cycle suivant, le complément du binaire qui serait normalement inséré suivant les circuits logiques cycliques du registre de retour linéaire.

2. Générateur de motifs de contrôle suivant la revendication 1, dans lequel les circuits logiques cycliques (166) sont à même de générer une séquence de motifs de contrôle pseudo-aléatoire.

3. Générateur de motifs de contrôle suivant la revendication 1 ou la revendication 2, comprenant en outre des moyens d'initialisation (100, 104) pour régler la valeur initiale du registre à décalage (155) à n étages.

4. Générateur de motifs de contrôle suivant la revendication 4, dans lequel les circuits logiques supplémentaires (108) comprennent des moyens destinés à fournir, à l'entrée de sélection du multiplexeur, un signal consistant en un ET logique d'une pluralité de sorties (140-144) des étages (120-125) du registre à décalage.

5. Générateur de motifs de contrôle suivant la revendication 4, dans lequel les sorties (140-144) des étages (120-125) du registre à décalage sont des sorties non inversées ou des sorties inversées.

EP 0 340 694 B1

Fig. 1 (PRIOR ART)

Fig. 2 (PRIOR ART)

Fig. 3

Fig. 4

10

Fig. 5

EP 0 340 694 B1

Fig. 6

*Fig. 7*

EP 0 340 694 B1

*Fig. 8*

EP 0 340 694 B1

*Fig. 9*

EP 0 340 694 B1

*Fig. 10*

EP 0 340 694 B1

*Fig. 11*

Fig. 12